# EUROPEAN PATENT APPLICATION

(11) **EP 2 284 874 A1**
(43) Date of publication of application: **16.02.2011**
(21) Application number: 09754429.0
(22) Date of filing: 26.05.2009
(51) Int. Cl.: H01L 21/312, H01L 21/3065, H01L 21/768, H01L 23/522

(54) **METHOD OF PRODUCING SILYLATED POROUS INSULATING FILM, METHOD OF PRODUCING SEMICONDUCTOR DEVICE, AND SILYLATED MATERIAL**

(30) Priority: 29.05.2008 JP 2008141485
(71) Applicant: Renesas Electronics Corporation, Kanagawa 211-8668 (JP); ULVAC, INC., Chigasaki-shi Kanagawa 253-8543 (JP)
(72) Inventor: KINOSHITA, Keizo, Kanagawa 211-8668 (JP); CHIKAKI, Shinichi, Kanagawa 211-8668 (JP); NAKAYAMA, Takahiro, Tsukuba-shi Ibaraki 300-2635 (JP)
(74) Representative: Glawe, Delfs, Moll
(86) International application number: PCT/JP2009/002314
(87) International publication number: WO 2009/144920

(57) **Abstract**

To appropriately perform the silylation treatment to a silica-based porous dielectric film having a plurality of pores, a method of manufacturing a silylated porous dielectric film 204c includes forming a porous dielectric film 204b having a plurality of pores and applying, to the porous dielectric film 204b, the silylation material vapor 210 obtained by evaporating the silylation material containing an organic silane compound having a hydrophobic group and a polymerization inhibitor for suppressing self-polymerization of the organic silane compound.

## Description

### TECHNICAL FIELD

The present invention relates to a method of manufacturing a silylated porous dielectric film, a method of manufacturing a semiconductor device, and a silylation material.

### BACKGROUND ART

Recently, in semiconductor devices having a multilayered interconnected structure, a porous dielectric film has been used as a low-dielectric-constant interlayer dielectric film. For example, as for the porous low-dielectric-constant (low-k) interlayer dielectric film, a film containing a siloxane polymer as a basic structure exists. Such a low-k interlayer dielectric film can be manufactured, for example, in the following sequence. First, a solution obtained by mixing a raw material containing a siloxane bond such as alkoxysilanes or the like and a raw material having volatility functioning as templates for mesoscale pores (having a diameter of 1 to several nanometers) is spin-coated on a substrate. Subsequently, the template materials are volatilized by performing baking treatment in a furnace. As a result, portions where the template materials are volatilized respectively become pores so that a porous dielectric film containing a siloxane polymer as a basic structure, generated from a material containing a siloxane bond, is formed on the substrate.

However, the aforementioned porous dielectric film tends to absorb moisture in this state and is likely to lose the low dielectric constant property. Non-patent Document 1 discloses a technique in which porous silica as the porous low-dielectric-constant film is annealed under a 1,3,5,7-tetramethylcyclosiloxane (TMCTS) vapor atmosphere. As a result, it is considered that the TMCTS molecule reacts with the Si-OH group on the surfaces of each pores of the porous film to form a polymer network with the result that the hydrophobicity and the strength of the porous silica are improved.

Patent Document 1 (Japanese Unexamined Patent Publication No. 2005-89448) discloses a technique in which, in the case where the cyclotetrasiloxane is used as a chemical vapor deposition (CVD) precursor when a silicon oxide such as a silicon oxide film is formed using a CVD method, an effective amount of a free radical polymerization retarder is added.
[Patent Document 1] Japanese Unexamined Patent Publication No. 2005-89448
[Non-patent Document 1] K. Kohmura, et al., "Novel organosiloxane vapor annealing process for improving properties of porous low-k films", Thin Solid Films, 515, 5019 (2007)

### DISCLOSURE OF THE INVENTION

In the technique described in Non-patent Document 1, viscosity of the material increases due to the self-polymerization of the TMCTS so as to generate problems such as difficulty in handling as a treatment solution or malfunction caused by blocking in pipes of a silylation apparatus.

According to the present invention, there is provided method of manufacturing a silylated porous dielectric film, the method including:
forming a silica-based porous dielectric film having a plurality of pores; and
applying, to the silica-based porous dielectric film, a silylation gas obtained by evaporating a silylation material containing an organic silane compound having a hydrophobic group and a polymerization inhibitor for suppressing self-polymerization of the organic silane compound.

According to the present invention, there is provided a method of manufacturing a semiconductor device, including:
forming a silica-based porous dielectric film having a plurality of pores over a substrate; and
applying, to the silica-based porous dielectric film, a silylation gas obtained by evaporating a silylation material containing an organic silane compound having a hydrophobic group and a polymerization inhibitor for suppressing self-polymerization of the organic silane compound.

According to the present invention, there is provided a silylation material for applying to a silica-based porous dielectric film having a plurality of pores in an evaporated state to hydrophobize or impart hydrophobic properties to and strengthen the silica-based porous dielectric film, including:
an organic silane compound having a hydrophobic group; and
a polymerization inhibitor for suppressing self-polymerization of the organic silane compound.

According to the investigation of the present inventors, it is perceived that, in the case where the polymerization inhibitor is not added (the concentration of the polymerization inhibitor is set to 0 ppm), in the silylation material, the organic silane compound is self-polymerized, so that the stability of the silylation material is problematic. Particularly, it is perceived that addition of the polymerization inhibitor is necessary to stabilize the silylation material for a sufficient time period to suppress self-polymerization of such an organic silane compound and apply the silylation treatment industrially.
According to the configuration of the present invention, it is possible to prevent self-polymerization of the organic silane compound and appropriately perform the silylation treatment.
In addition, here, as the polymerization inhibitor, for example, phenol, hydroquinone, or one of their compounds may be used.

Furthermore, any combinations of the aforementioned elements and any modifications of the expression of the present invention with regard to methods and apparatuses are also effective as an aspect of the present invention.

According to the present invention, it is possible to appropriately perform the silylation treatment of the silica-based porous dielectric film having a plurality of pores.

### BRIEF DESCRIPTION OF THE DRAWINGS

The aforementioned and other objects, characteristics, and advantages will be made more apparent by the following preferable embodiments and the following accompanying drawings.

Fig. 1 is a process cross-sectional diagram illustrating a sequence of forming a silylated porous dielectric film according to an embodiment of the present invention.
Fig. 2 is a process cross-sectional diagram illustrating a sequence of manufacturing a semiconductor device according to an embodiment of the present invention.
Fig. 3 is a process cross-sectional diagram illustrating a sequence of manufacturing a semiconductor device according to an embodiment of the present invention.
Fig. 4 is a diagram illustrating a result of measurement of the characteristics of the porous dielectric film in the case where the concentration of the polymerization inhibitor to the organic silane compound in the silylation material during the silylation treatment is varied and the case where the silylation treatment is not performed.
Fig. 5 is a diagram illustrating a result of observation using a transmission electron microscope by cutting away the semiconductor device in the case where the concentration of the polymerization inhibitor to the organic silane compound in the silylation material during the silylation treatment is varied and the case where the silylation treatment is not performed.

### BEST MODE FOR CARRYING OUT THE INVENTION

Hereinafter, embodiments of the present invention will be described with reference to the accompanying drawings. Throughout all of the drawings, like reference numerals denote like elements, and their descriptions will not be repeated.

### (First Embodiment)

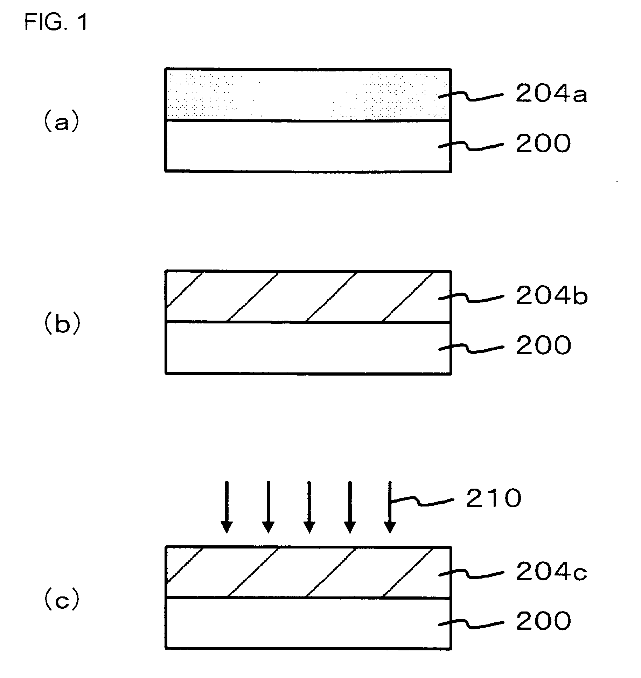

Fig. 1 is a process cross-sectional diagram illustrating a sequence of forming the silylated porous dielectric film according to the present embodiment.
In the present embodiment, the silylated porous dielectric film 204c is formed in the following sequence.
First, a porous dielectric film material 204a, which is a solution obtained by mixing a material containing a siloxane bond (-Si-O-Si-) such as alkoxysilanes or the like and a template material having a high volatility and functioning as templates for the mesoscale pores, is spin-coated on the substrate 200 (Fig. 1(a)). The substrate 200 may be made of, for example, a silicon substrate or the like. In addition, an element such as a transistor, a semiconductor element, and an interconnect structure, and the like may be formed on the substrate 200.

Subsequently, the template material is volatilized by performing baking treatment (heat treatment) using a furnace. As a result, portions where the template material is volatilized become pores, and a siloxane polymer is used as a basic structure, so that a porous dielectric film 204b having a plurality of pores is formed on the substrate 200 (Fig. 1(b)). For example, the porous dielectric film 204b may include porous silica, porous methyl-silsesquioxane (MSQ), porous SiOCH, or the like.

In the present embodiment, as the alkoxysilanes, for example, tetraethoxysilane (TEOS) may be used. In addition, for example, a triblock copolymer, a sort of surfactant agent, may be used as the template material. Using such materials, the triblock copolymer forms micelles in the aqueous solution, and an oligomer of the TEOS is arranged around it. In the case where this solution is spin-coated on the substrate 200, the micelles are periodically or randomly arranged on the substrate 200. As a result, pores are periodically or randomly arranged in the porous dielectric film 204b formed after the baking treatment. The arrangement of pores becomes random if an additive having a Si-CH₃ bond is present, or becomes periodic otherwise.

Here, since the porous dielectric film 204b of this state has a large surface area due to pores provided therein, the porous dielectric film 204b tends to absorb water. Since water has a large relative dielectric constant of 80, as the porous dielectric film 204b absorbs water, the relative dielectric constant of the porous dielectric film 204b increases. In addition, there is also a problem that the -Si-O-Si- bond forming the porous dielectric film 204b may react with H₂O so as to break the bond. When the -Si-O-Si- bond is broken, an Si-OH bond is formed so that the elastic modulus of the porous dielectric film 204b decreases. In addition, since the porous dielectric film 204b has pores, it has a lower mechanical strength in comparison with a film without pores. In this regard, in the present embodiment, a silylation treatment using a silylation material is performed so that the porous dielectric film 204b is imparted hydrophobic properties and simultaneously strengthened to improve characteristics.

In the present embodiment, the silylation material vapor 210 (silylation gas) obtained by vaporizing the silylation material containing an organic silane compound having a hydrophobic group and a polymerization inhibitor for suppressing self-polymerization of the organic silane compound, is applied to the porous dielectric film 204b.

The present inventors have discovered a problem that the silylation treatment is not effectively performed, and it is difficult to obtain the effect of the performance improvement_of the porous dielectric film if the additive amount of the polymerization inhibitor is not properly controlled in the case where the organic silane compound is used when the porous dielectric film is imparted hydrophobic properties.

In the silylation material of the present embodiment, it is possible to set the concentration of the polymerization inhibitor to the organic silane compound to be equal to or higher than 100 ppm (weight). By setting the lower limit of the concentration of the polymerization inhibitor to such a level, it is possible to suppress the self-polymerization of the organic silane compound and stabilize the silylation material for a sufficient time period in order to apply the silylation treatment industrially.

It is preferable that the concentration of the polymerization inhibitor is high in order to stabilize the organic silane compound at a high temperature for a long time. However, according to the investigation of the inventors, it is perceived that, if the concentration of the polymerization inhibitor to the organic silane compound is too high in the case where the polymerization inhibitor is added to stabilize the silylation material, the hydrophobicity or the effect of improving the mechanical strength of the silica-based porous dielectric film is degraded even if the silylation treatment is performed. It is considered that, if the concentration of the polymerization inhibitor is too high, a large amount of polymerization inhibitor stays in the pore portions of the porous dielectric film, so that reaction between the organic silane compound and the porous dielectric film is inhibited, and the silylation treatment does not proceed sufficiently. In the silylation material of the present embodiment, it is possible to set the concentration of the polymerization inhibitor to the organic silane compound to be lower than 500 ppm. By setting the upper limit of the concentration of the polymerization inhibitor in this manner, it is possible to sufficiently obtain the effect of increasing the hydrophobicity or the mechanical strength of the silica-based porous dielectric film through the silylation treatment.

If the concentration of the polymerization inhibitor to the organic silane compound is set to the aforementioned range, it is possible to stabilize the silylation material for a sufficient time period to apply the silylation treatment industrially and simultaneously obtain the effect of increasing the hydrophobicity or the mechanical strength of the silica-based porous dielectric film through the silylation treatment.

As the polymerization inhibitor, for example, phenol, hydroquinone, or one of their compounds may be used. Details of such a polymerization inhibitor are described in Patent Document 1, and a free radical polymerization retarder disclosed in Patent Document 1 or the like may be used.

The organic silane compound having the hydrophobic group may include a Si-H group and a hydrophobic group at least in the Si-O base structure. Here, the hydrophobic group may function as a functional group for giving hydrophobicity to a material after the silylation treatment, such as an alkyl group, an allyl group, an alkynyl group, an aryl group, an alkylene group and the like. As the organic silane compound having the hydrophobic group, for example, 1,3,5,7-tetramethylcyclosiloxane (TMCTS) or the like may be used.

The substrate 200 and the porous dielectric film 204b are arranged in the annealing furnace, and the aforementioned silylation material is introduced to the annealing furnace by evaporating an inert gas such as nitrogen gas, helium gas or the like as a carrier gas using the carburetor. Here, the temperature of the annealing furnace may be set to be equal to or higher than 200°C and equal to or lower than 500°C, for example, approximately 350°C. The gas pressure, as a total pressure, may be set to be equal to or higher than approximately 1 kPa and equal to or lower than approximately 50 kPa, and more preferably, be equal to or higher than approximately 4 kPa and equal to or lower than approximately 30 kPa. As a result, it is possible to allow the silylation gas contained in the mixed gas to be easily absorbed on the surface of the porous dielectric film 204b and the surface of the pores. The treatment time may be set to, for example, approximately 120 minutes.

Through the aforementioned treatment, a defect in the fine silica base structure on the surface of the inner wall of the pores of the porous dielectric film 204b is covered by the silylation material and its polymerization reactant, and at the same time, hydrophobicity caused by the organic functional group introduced by the silylation material is given so that the silylated porous dielectric film 204c having hydrophobic properties and strengthened is provided (Fig. 1(c)). In addition, there is an effect that it is possible to hydrophobize or impart hydrophobic properties to the surface of the porous dielectric film 204b and also to the surface of the internal fine holes by performing the silylation using the mixed gas containing a silylation gas and an inert gas.

Next, advantages of the present embodiment will be described.
By adding the polymerization inhibitor to the organic silane compound in the silylation material during the silylation treatment, it is possible to suppress the self-polymerization of the organic silane compound and stabilize the silylation material for a sufficient time period to apply the silylation treatment industrially. As a result, it is possible to appropriately perform the silylation treatment of the silica-based porous dielectric film having a plurality of pores.

Furthermore, it is possible to obtain the following effects by appropriately controlling the concentration of the polymerization inhibitor to the organic silane compound in the silylation material during the silylation treatment.

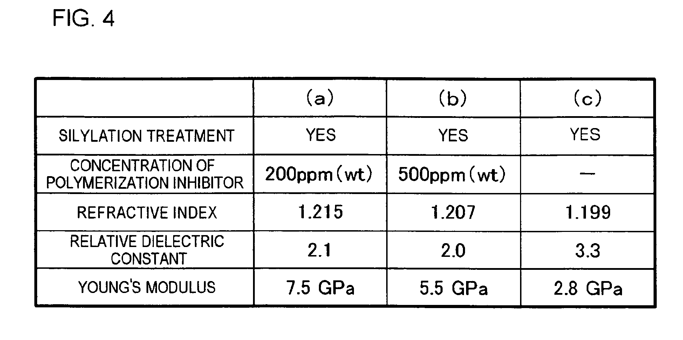

Fig. 4 shows the results of measurement of the characteristics of the porous dielectric film in the case where the concentration of the polymerization inhibitor to the organic silane compound in the silylation material during the silylation treatment is varied and the case where the silylation treatment is not performed.

The porous dielectric film was formed under the following conditions, and characteristics were measured.
(a) The silylation treatment was performed by setting the concentration of the polymerization inhibitor to the organic silane compound in the silylation material during the silylation treatment to 200 ppm (weight).
(b) The silylation treatment was performed by setting the concentration of the polymerization inhibitor to the organic silane compound in the silylation material during the silylation treatment to 500 ppm (weight).
(c) The silylation treatment was not performed.

It was possible to maintain a low relative dielectric constant in the porous dielectric film subjected to the silylation treatment of the conditions (a) and (b). Meanwhile, the porous dielectric film of the condition (c), not subjected to the silylation treatment, has a higher relative dielectric constant. It is considered that this is because of absorption of moisture. In the case where the concentration of the polymerization inhibitor is high as in the condition (b) even when the silylation treatment is performed, an YOUNG's modulus was 5. 5 GPa, which represents a lower mechanical strength, in comparison with 7.5 GPa of the condition (a). It is considered that, if the concentration of the polymerization inhibitor is too high, a large amount of polymerization inhibitor is present in the pore portions of the porous dielectric film, and the reaction between the organic silane compound and the porous dielectric film is inhibited, so that the silylation treatment does not proceed sufficiently.

In addition, it was possible to obtain the same result as that of the condition (a) even in the case where the concentration of the polymerization inhibitor to the organic silane compound in the silylation material during the silylation treatment was set to 300 ppm (weight), 400 ppm (weight), and 450 ppm (weight). In the case where the polymerization inhibitor was not added to the organic silane compound in the silylation material during the silylation treatment, it was impossible to perform the silylation treatment due to the self-polymerization generated in the carburetor maintained at a temperature of 150°C in order to perform evaporation by mixing with the carrier gas. Furthermore, in the case where the concentration of the polymerization inhibitor to the organic silane compound in the silylation material during the silylation treatment was set to approximately 50 ppm (weight), it was impossible to appropriately perform the silylation treatment because the carburetor maintained at a temperature of 150°C in order to perform evaporation by mixing with the carrier gas became blocked for a month due to the self-polymerization.

As described above, according to the method of manufacturing the silylated porous dielectric film 204c of the present embodiment, it is possible to increase the mechanical strength characteristics such as elastic modulus, hardness, and toughness of the porous dielectric film and simultaneously increase hydrophobicity to prevent moisture absorption and maintain a low relative dielectric constant. As a result, it is possible to obtain desired characteristics of an integrated circuit during the manufacturing of semiconductor devices such as a semiconductor integrated circuit and prevent exfoliation or breakdown of the porous dielectric film during the manufacturing process of the semiconductor device.

### (Second Embodiment)

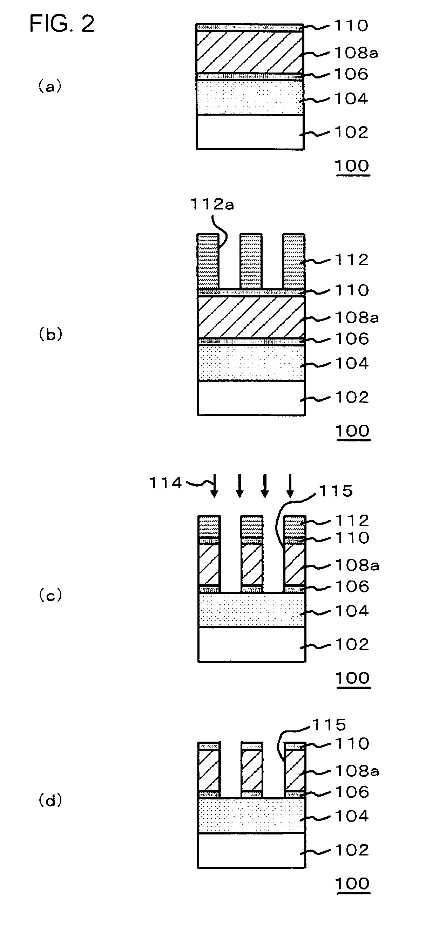

Fig. 2 is a process cross-sectional diagram illustrating a sequence of manufacturing the semiconductor device according to the present embodiment.
The semiconductor device 100 includes a substrate 102, an dielectric film 104, an etching stopper film 106, a porous interlayer dielectric film 108a, and a cap film 110 formed in this order on the substrate 102. For example, the substrate 102 may be a semiconductor substrate such as a silicon substrate. Although not shown herein, elements such as a transistor are formed on the substrate 102. For example, the dielectric film 104 may be made of a silicon oxide film or the like. Although the dielectric film 104 is shown as a single layer herein, the dielectric film 104 may have a stack structure of a plurality of dielectric films.

The porous interlayer dielectric film 108a may be manufactured in the same sequence as that of the porous dielectric film 204b described in conjunction with the first embodiment. In the present embodiment, the silylation treatment is not performed in this step.

The etching stopper film 106 may be an SiCN film formed through, for example, a plasma CVD method. The cap film 110 may be a SiCN film formed through, for example, the plasma CVD method similar to that of the etching stopper film 106.

On such a stack structure, a resist film 112 (mask film) having an opening 112a for forming an interconnect trench is formed using a photolithography technique (Fig. 2(b)). Subsequently, the cap film 110 underlying the resist film 112, the porous interlayer dielectric film 108a, and the etching stopper film 106 are dry-etched by using the resist film 112 as a mask to form the interconnect trench 115 (the concave portion) within such an dielectric film (Fig. 2(c)). Here, the dry etching may be performed using plasma 114 of a mixed gas containing a fluorocarbon gas such as C₄F₈ or the like, an inert gas such as argon or the like, and an oxidizing gas such as oxygen or the like.

Next, the resist film 112 is removed by peeling-off (Fig. 2(d)). The resist film 112 may be peeled off or removed by first performing treatment using plasma of a mixed gas containing helium and hydrogen at a high temperature of approximately 350°C and then performing a cleaning process using a carboxylate aqueous solution containing ammonium fluoride.

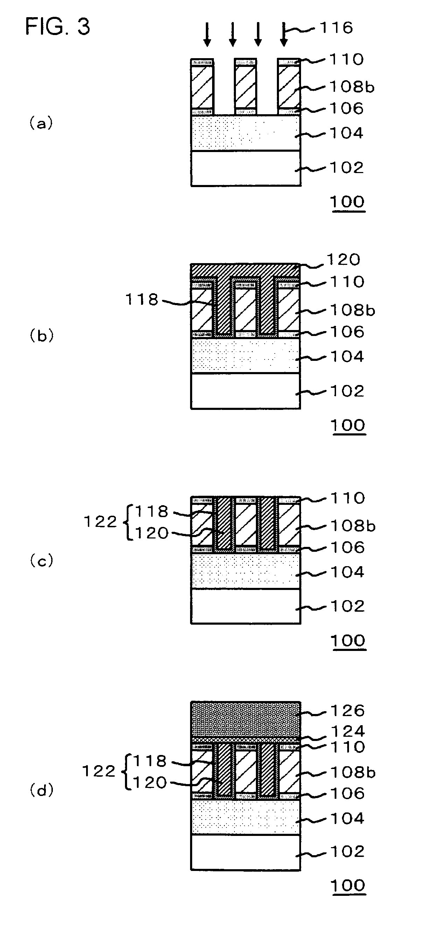

Subsequently, the silylation treatment is performed by applying vapor of the silylation material 116 (silylation gas). The present embodiment may also be performed through the same sequence as that of the silylation treatment of the first embodiment. In addition, similar to the first embodiment, the concentration of the polymerization inhibitor to the organic silane compound in the silylation material during the silylation treatment may be appropriately controlled in the present embodiment. Here, the treatment time may be set to, for example, approximately 30 minutes. As a result, a defect in the fine silica structure on the surface of the inner wall of the pores of the porous interlayer dielectric film 108a is covered by the silylation material and its polymerization reactant, and at the same time, hydrophobicity caused by the organic functional group introduced by the silylation material is given so that the silylated porous interlayer dielectric film 108b having hydrophobic properties and strengthened is provided (Fig. 3(a)).

Then, a conductive film is formed on the entire surface of the substrate 102, and the interconnect trench 115 is buried by the conductive film. Here, the conductive film may be made from the barrier metal film 118 and the interconnect metal film 120. First, the barrier metal film 118 is formed through a sputtering method (PVD method), and a copper seed layer functioning as an electrode for electrolytic plating is formed. Then, the interconnect metal film 120 is formed through electrolytic plating in order to bury the interconnect trench 115 (Fig. 3(b)). The interconnect metal film 120 may be made of a material containing copper as a main component.

Subsequently, the barrier metal film 118 and the interconnect metal film 120 exposed out of the interconnect trench 115 are removed through a chemical mechanical polishing (CMP) method to form the interconnect 122 (Fig. 3(c)). Then, the barrier dielectric film 124 and the dielectric film 126 are stacked in this order on the cap film 110 (Fig. 2(d)). The barrier dielectric film 124 may be used as an dielectric film having a function of preventing diffusion of copper, and may be formed of, for example, silicon nitride, silicon nitro-carbide, boron nitro-carbide, boron nitride, or the like. By repeating the aforementioned process, it is possible to obtain a multilayered interconnect structure.

Next, advantages of the semiconductor device 100 manufactured through the sequence of manufacturing the semiconductor device according to the present embodiment will be described.
In the present embodiment, it is possible to obtain the same advantages as those of the first embodiment.
In addition, it is possible to obtain the following advantages by appropriately controlling the concentration of the polymerization inhibitor to the organic silane compound in the silylation material during the silylation treatment according to the present embodiment.

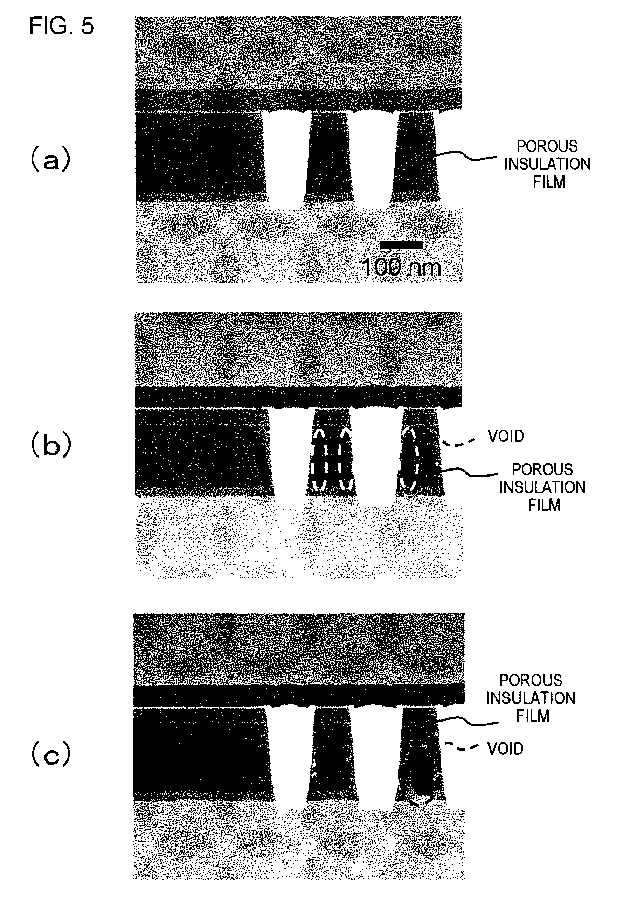

Fig. 5 is a diagram illustrating the result of observation using a transmission electron beam microscope by cutting away the semiconductor device in the case where the concentration of the polymerization inhibitor to the organic silane compound in the silylation material during the silylation treatment is varied and the case where the silylation treatment is not performed.

The semiconductor device was formed using the following conditions, and characteristics were measured.
(a) The silylation treatment was performed by setting the concentration of the polymerization inhibitor to the organic silane compound in the silylation material during the silylation treatment to 200 ppm (weight).
(b) The silylation treatment was performed by setting the concentration of the polymerization inhibitor to the organic silane compound in the silylation material during the silylation treatment to 500 ppm (weight).
(c) The silylation treatment was not performed.

Fig. 5(a) is a diagram illustrating the result of the semiconductor device manufactured under the aforementioned condition (a). Fig. 5(b) is a diagram illustrating the result of the semiconductor device manufactured under the aforementioned condition (b). Fig. 5(c) is a diagram illustrating the result of the semiconductor device manufactured under the aforementioned condition (c).

In Fig. 5(c) in which the silylation treatment was not performed, voids were formed such that the porous interlayer dielectric film was dissolved as shown as the dashed line in the drawing. It is considered that the porous interlayer dielectric film was dissolved because the fluorine component absorbed in the porous interlayer dielectric film during the dry etching process described in Fig. 2(c) and moisture in the subsequent process reacted to form the highly acidic hydrofluoric acid.

In Fig. 5(b) in which the concentration of the polymerization inhibitor was high in the condition (b), it was observed that voids were formed as enclosed by the dashed line in the drawing although they were small in comparison with Fig. 5(c). It is considered that, if the concentration of the polymerization inhibitor is too high, a large amount of polymerization inhibitor is present in the pore portions of the porous interlayer dielectric film 108a, and the reaction between the organic silane compound and the porous interlayer dielectric film 108a is inhibited, so that the silylation treatment does not proceed sufficiently. For this reason, it is considered that hydrofluoric acid was formed as in the condition (c), and the porous interlayer dielectric film dissolved.

Meanwhile, in the case (a) where the silylation treatment was performed, and simultaneously, the concentration of the polymerization inhibitor was appropriately controlled to be lower than 500 ppm, formation of such a void was not observed as shown in Fig. 5(a). It is considered that no hydrofluoric acid was formed, and no void was formed because the porous interlayer dielectric film 108a was sufficiently impated hydrophobic properties by controlling the concentration of the polymerization inhibitor. In addition, it was possible to obtain the same result as that of the condition (a) even in the case where the concentration of the polymerization inhibitor to the organic silane compound in the silylation material during the silylation treatment was set to 300 ppm (weight), 400 ppm (weight), and 450 ppm (weight).

In the process of manufacturing the semiconductor device 100, the porous interlayer dielectric film 108a tends to absorb moisture, for example, when the interconnect trench 115 is formed through the dry etching after the porous interlayer dielectric film 108a is formed. In addition, it is probable that various gases are introduced to the porous interlayer dielectric film 108a through the film on the surface when the barrier metal film 118 and the interconnect metal film 120 are formed in the interconnect trench 115 or during the CMP. In the present embodiment, the silylated porous interlayer dielectric film 108b is formed by performing the silylation treatment immediately after the interconnect trench 115 is formed on the porous interlayer dielectric film 108a through the dry etching. Therefore, it is possible to prevent moisture or gases from being absorbed or introduced in the silylated porous interlayer dielectric film 108b in the subsequent treatment.

While the embodiments of the present invention have been described with reference to the accompanying drawings, it is intended that these are provided as an example, and various other configurations may be employed.
The present application claims priority to Japanese Priority Patent Application JP 2008-141485 filed in the Japan Patent Office on May 29, 2008, the entire content of which is hereby incorporated by reference.

## Claims

1. A method of manufacturing a silylated porous dielectric film, the method comprising:
forming a silica-based porous dielectric film having a plurality of pores; and
applying, to said silica-based porous dielectric film, a silylation gas obtained by evaporating a silylation material containing an organic silane compound having a hydrophobic group and a polymerization inhibitor for suppressing self-polymerization of said organic silane compound.

2. The method according to claim 1,
wherein in said silylation material, the concentration of said polymerization inhibitor to said organic silane compound is lower than 500 ppm.

3. The method according to claim 1,
wherein said organic silane compound contains 1,3,5,7-tetramethylcyclosiloxane (TMCTS).

4. The method according to claim 1,
wherein said silica-based porous dielectric film is made of a material having a Si-O-Si bond.

5. A method of manufacturing a semiconductor device, comprising:
forming a silica-based porous dielectric film having a plurality of pores over a substrate; and
applying, to said silica-based porous dielectric film, a silylation gas obtained by evaporating a silylation material containing an organic silane compound having a hydrophobic group and a polymerization inhibitor for suppressing self-polymerization of said organic silane compound.

6. The method according to claim 5,
wherein in said silylation material, the concentration of said polymerization inhibitor to said organic silane compound is lower than 500 ppm.

7. The method according to claim 5,
wherein said organic silane compound contains 1,3,5,7-tetramethylcyclosiloxane (TMCTS).

8. The method according to claim 5,
wherein said silica-based porous dielectric film is made of a material having a Si-O-Si bond.

9. The method according to claim 5, further comprising, after said forming the silica-based porous dielectric film and before said applying the silylation gas, forming a mask film over said silica-based porous dielectric film and forming a concave portion in said silica-based porous dielectric film through dry etching using said mask film.

10. The method according to claim 9, further comprising, after said applying the silylation gas:
forming a conductive film over the entire surface of said substrate to bury said concave portion with said conductive film; and
removing said conductive film exposed out from said concave portion using a chemical mechanical polishing method.

11. A silylation material for applying to a silica-based porous dielectric film having a plurality of pores in an evaporated state to impart hydrophobic properties and strengthen said silica-based porous dielectric film, comprising:
an organic silane compound having a hydrophobic group; and
a polymerization inhibitor for suppressing self-polymerization of said organic silane compound.

12. The silylation material according to claim 11,
wherein, in the silylation material, the concentration of said polymerization inhibitor to said organic silane compound is lower than 500 ppm.

13. The silylation material according to claim 11,
wherein said organic silane compound contains 1,3,5,7-tetramethylcyclosiloxane (TMCTS).
